# EUROPEAN PATENT APPLICATION

(11) **EP 2 711 990 A1**
(43) Date of publication of application: **26.03.2014**
(21) Application number: 12185495.4
(22) Date of filing: 21.09.2012
(51) Int. Cl.: H01L 31/0376, H01L 31/048, H01L 31/052, H01L 31/075, H01L 31/20

(54) **Solar module and its production process**

(71) Applicant: Ecole Polytechnique Fédérale de Lausanne (EPFL), 1015 Lausanne (CH)
(72) Inventor: Perret-Aebit, Laure-Emmanuelle, 2000 Neuchâtel (CH); Heinstein,Patrick, 2000 Neuchâtel (CH); Despeisse, Matthieu, 2000 Neuchâtel (CH); Ballif, Christophe, 2000 Neuchâtel (CH); Stückelberger, Michael, 8057 Zürich (CH)
(74) Representative: GLN SA

(57) **Abstract**

The present invention relates to a solar module comprising a front sheet (30), an amorphous silicon photoelectric device (32) comprising at least a transparent front electrode layer (34), a p-type doped silicon layer (36), an intrinsic silicon layer (38), a n-type doped silicon layer (40), and a transparent back electrode layer (42), a back reflector (44), and a back sheet (46).

The intrinsic silicon layer (38) of the amorphous silicon photoelectric device (32) has a thickness comprised between 50 nm and 300 nm, and preferably comprised between 100 nm and 200 nm. Moreover, the solar module further comprises, between the amorphous silicon photoelectric device (32) and the back reflector (44), a colored encapsulant layer (48) which comprises a coloring agent chosen in such a way that the solar module has a color within a region defined by an x value of 0.15 to 0.75 and a y value of 0.10 to 0.70, and preferably defined by an x value of 0.28 to 0.65 and a y value of 0.20 to 0.50, in a chromaticity diagram of a CIE 1931 Yxy color system.

Such solar modules have a uniform terracotta color similar to the color of traditional roof tiles and can be easily incorporated into the architecture of the buildings.

## Description

### Technical Field

The present invention relates to the field of solar modules. More particularly, it relates to a solar module comprising:
- a front sheet,
- an amorphous silicon photoelectric device comprising at least a transparent front electrode layer, active layers, which comprise a p-type doped Si layer, an intrinsic Si layer, a n-type doped Si layer, and a transparent back electrode layer,
- a back reflector, and
- a back sheet.

The invention also relates to a method for producing this solar module.

A particularly advantageous application of the present invention is for the production of photovoltaic modules intended for generating electrical energy, but the invention also applies, more generally, to any structure in which light radiation is converted into an electrical signal, such as photodetectors.

### Background of the invention

Thin film silicon solar modules can be produced in the superstrate (p-i-n) and in the substrate (n-i-p) configurations. They make use of hydrogenated amorphous silicon (a-Si:H) and microcrystalline silicon materials (µc-Si:H). Thin film silicon solar modules can be designed as single pin (nip) junctions as well as multi-junctions consisting in pin-pin (nip-nip) and pin-pin-pin (nip-nip-nip)stacked modules in order to optimize the use of the full solar spectrum, allowing for improved efficiencies.

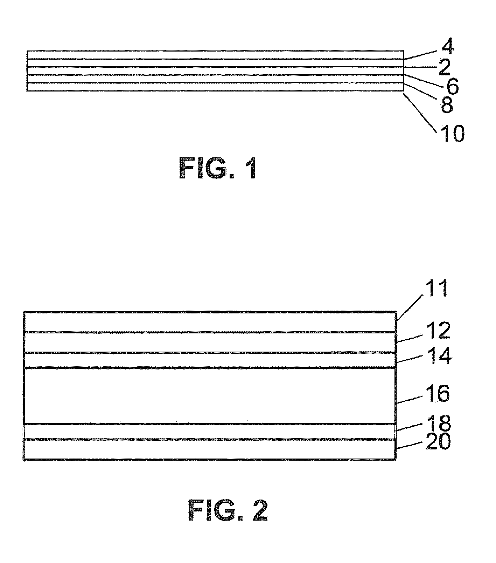

The typical prior art relating to the thin film silicon solar module architecture in the superstrate configuration is detailed in Figure 1. The silicon active layers, comprising a p-type doped Si layer, an intrinsic Si layer, a n-type doped Si layer, and the front and the back electrodes, all constituting the thin film silicon solar module 2, are all together deposited on a front glass 4 and scribed to ensure series interconnection of the thin film silicon active segments. Then the thin film silicon module encapsulation process is based on a back reflector 6 (polymer, paint or metallic layer), a polymeric sheet 8 (Poly vinyl butyral PVB, Ethylene vinyl acetate EVA, Ionomer, Silicon, Polyolefin) of a thickness between 0.2 - 1.5 mm, and a back glass 10 (glass/glass configuration) or a back sheet (glass/foil configuration). An edge sealing (0.3 - 2 cm width) can be used in addition to tightly close the module edges from external contamination.

Typical lamination processes are used for the encapsulation process and take place between 80 - 200°C under vacuum and at a pressure between 400 - 1000 mbars. Typical assemblies of thin film photovoltaic modules and lamination process are described in the patent applications US 2011/0220185, US 7,868,246, US 2011/0041891, US 6,288,326 and US 2011/0237021. Typical polymeric encapsulants are poly vinyl butyral (PVB) (US 2010/0180943, US 2011/0056555), ethylene vinyl acetate (EVA) (US 2007/0122629), ionomers (US 7,902,452), silicone (US 2008/ 0276983) and fluoropolymers based materials (US 2011/70129676).

Thin film silicon modules typically have a brownish (a-Si:H single junctions) or black (multiple junctions) color rendering, uniform over the module, appealing for aesthetically pleasing integration into buildings. The typical prior art single junction a-Si:H solar modules active layers design is shown in Figure 2. First a transparent conductive oxide (TCO) layer 12 is deposited on a glass sheet 11 to act as front electrode. Then a positively doped silicon layer 14 is deposited on the TCO 12 (with a thickness of 5 - 50 nm), followed by a silicon intrinsic layer 16 (with a thickness of 200 - 300 nm), a negatively doped silicon layer (18) (with a typical thickness of 10 - 100 nm) and a back TCO layer (20).

Such a-Si:H single junction solar modules can be found on the market with efficiencies in the order of 7 - 7.4 % in the superstrate configuration. Typical architectures can for example be found in the patent publications WO 2012/065957 and in WO 2011/076466.

Architectural integration of solar energy systems into buildings has become a widely recognized issue. While typical brown and black uniform colors of thin film silicon are already attractive for building integration, there is a need of module design providing outstanding possibilities of architectural integration thanks to a uniform color similar to that of traditional roof tiles.

### Summary of the invention

An object of the present invention is to propose a solar module which is attractive for building integration by exhibiting a uniform color similar to that of traditional roof tiles

Accordingly, the present invention relates to a solar module comprising at least:
- a front sheet,
- an amorphous silicon photoelectric device comprising at least a transparent front electrode layer, a p-type doped silicon layer, an intrinsic silicon layer, a n-type doped silicon layer, and a transparent back electrode layer,
- a back reflector, and
- a back sheet.

According to the invention, the intrinsic silicon layer of the amorphous silicon photoelectric device has a thickness comprised between 50 nm and 300 nm, and preferably comprised between 100 nm and 200 nm.

Moreover, the solar module further comprises, between the amorphous silicon photoelectric device and the back reflector, a colored encapsulant layer which comprises a coloring agent chosen in such a way that the solar module has a color within a region defined by an x value of 0.15 to 0.75 and a y value of 0.10 to 0.70, and preferably defined by an x value of 0.28 to 0.65 and a y value of 0.20 to 0.50, in a chromaticity diagram of a CIE 1931 Yxy color system using a white light source measured with a D65 light source.

The present invention relates also to a method for producing a solar module as defined below, said method comprising the following steps of:
- depositing on a front sheet an amorphous silicon photoelectric device comprising at least a transparent front electrode layer, a p-type doped silicon layer, an intrinsic silicon layer, a n-type doped silicon layer, and a transparent back electrode layer, the intrinsic silicon layer of the amorphous silicon photoelectric device having a thickness comprised between 50 nm and 300 nm, and preferably comprised between 100 nm and 200 nm;
- depositing on the amorphous silicon photoelectric device a colored encapsulant layer which comprises a coloring agent chosen in such a way that the solar module has a color within a region defined by an x value of 0.15 to 0.75 and a y value of 0.10 to 0.70, and preferably defined by an x value of 0.28 to 0.65 and a y value of 0.20 to 0.50, in a chromaticity diagram of a CIE 1931 Yxy color system using a white light source measured with a D65 light source;
- depositing on the coloured encapsulant layer a back reflector, and
- depositing on the back reflector a back sheet.

The solar module of the invention has a uniform terracotta color similar to the color of traditional roof tiles and can be easily incorporated into the architecture of the buildings.

### Brief description of the drawings

Figure 1 is a schematic cross-section of a typical assembly of a thin film silicon module of the prior art,

Figure 2 is a schematic cross-section of a typical amorphous silicon (a-Si:H) single junction solar module of the prior art, and

Figure 3 is a schematic cross-section of a solar module of the invention. Detailed description

In the present description, the term "back" means something which is the farthest away from the incoming light side and the term "front" means something which is the closest to the incoming light side.

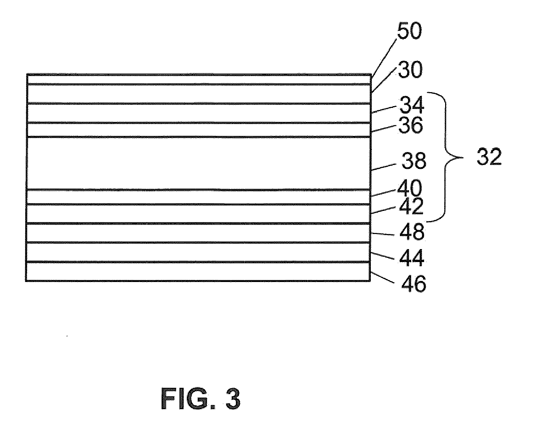

In reference to Figure 3, a solar module according to the invention comprises at least:
- a front sheet 30,
- an amorphous silicon photoelectric device 32 comprising at least a transparent front electrode layer 34, a p-type doped silicon layer 36, an intrinsic silicon layer 38, a n-type doped silicone layer 40, and a transparent back electrode layer 42,
- a back reflector 44,
- a back sheet 46.

According to the invention, the a-Si:H intrinsic layer 38 of the amorphous silicon photoelectric device 32 has a thickness comprised between 50 nm and 300 nm, and preferably comprised between 100 nm and 200 nm.

By using thicknesses of 50 nm to 300 nm, and preferably of 100 nm to 200 nm of the a-Si:H absorber or intrinsic layer 38, a higher proportion of light with wavelength below 550 nm is reflected out of the panel thanks to a reduced absorption in the photoactive material. In the present invention, the thickness of the a-Si:H intrinsic layer 38 is tailored to vary the color aspect of the thin film silicon a-Si:H solar modules. Most interestingly, this variation of the color aspect of the module is achieved without a strong impact on the module efficiency. This arises from the fact that the thinner is the a-Si:H photoactive element, the lower is the photoinduced degradation (commonly referred to as Staebler-Wronski effect) of the electrical performances Consecutively, even though the thinner absorber layer leads to a decreased light absorption (pre-requisite to alter the color rendering by enhancing light reflected out of the module), the increased electrical performances result into a performance loss below 3% relative for absorber thicknesses in the range of 100 nm to 200 nm. By implementing such "thinner" silicon layers, a shift of the module color is clearly induced towards terra cotta colours.

Typically, the p-type doped silicon layer 36 has a thickness comprised between 5 nm and 50 nm, and the n-type doped silicon layer 40 has a thickness comprised between 10 nm and 100 nm, as used in the solar module of the prior art.

Moreover, according to the invention, the solar module further comprises, between the amorphous silicon photoelectric device 32 and the back reflector 44, a colored encapsulant layer 48 which comprises a coloring agent chosen in such a way that the solar module has a color within a region defined by an x value of 0.15 to 0.75 and a y value of 0.10 to 0.70, and preferably defined by an x value of 0.28 to 0.65 and a y value of 0.20 to 0.50, in a chromaticity diagram of a CIE 1931 Yxy color system using a white light source measured with a D65 light source.

Preferably, the colored encapsulant layer 48 may be a polymeric layer, using the typical polymeric encapsulants disclosed in the "background of the invention" section, as poly vinyl butyral (PVB), ethylene vinyl acetate (EVA) ionomers, polyolefin, silicone and fluoropolymers based materials.

Said colored encapsulant layer 48 has a thickness comprised between 0.15 mm and 0.5 mm.

Advantageously, the coloring agent used in the colored encapsulant layer 48 may be selected from the group comprising organic pigments, inorganic pigments, polymeric pigments and dyes, said coloring agent having a color allowing to obtain the color of the solar module as defined above. Preferably, the colored encapsulant layer 48 may be based on UWin EVA supplied by Guangzhou Uwin Houseware Company Limited, Huayi EVA supplied by Shanghai Huayi Plastics Auxiliary Cooperation Company, Sanken EVA supplied by Guangzhou S&K Glass Machinery Co. Ltd. or Trosifol® colour supplied by Kuraray.

The application of said colored encapsulant layer 48 directly after the back electrode layer 42 permits to tailor the back reflected light spectrum to ensure an enhancement of the terra-cotta color rendering at the module surface.

In comparison with the products currently found on the market, where the possible modifications of the product are made at high costs (e.g., by changing the thickness of the antireflective layer on the crystalline cells), the solar modules of the invention may be produced from standard solar modules without expensive modifications. These photovoltaic elements will not only produce electricity but will also be considered as elements incorporated into the architecture of the buildings.

CIE Yxy coordinates of the reference traditional roof tiles are x=0.46, y= 0.39.

The terracotta color of the solar module of the invention ranges preferably from x= 0.28 - 0.65 and y= 0.20 - 0.50.

The front sheet 30 may be any transparent material. Advantageously, the front sheet 30 is a glass sheet.

Typically, said front sheet 30 has a thickness comprised between 1 mm and 6 mm.

In order to improve even further the aesthetic color of the solar module of the invention, an anti-reflection scheme can be applied at the front glass surface.

In one embodiment, as shown by Figure 3, the solar module of the invention may further comprise a textured glass sheet 50 deposited on the front sheet 30.

In other embodiment, the front sheet 30 may be a textured glass sheet obtained by imprinting or embossing textures or etching at the front glass sheet 30 to ensure a rough air/glass interface.

This additional feature permits to conserve a uniform terra-cotta color rendering for any angles of incidence of the incoming light and any angles of perspective of the observer and it reduces the primary reflection of light at high incident angle light which can create a dazzle.

The transparent front electrode layer 34 may be made of any suitable materials, and is preferably a transparent conducting oxide (TCO) layer. Advantageously, such transparent front electrode layer 34 may be made of a material selected from the group comprising FTO (fluorinated tin oxide), ITO (indium tin oxide), IOH (hydrogen doped indium oxide), ZnO and SnO₂.

Typically, said transparent front electrode layer 34 has a thickness comprised between 400 nm and 2000 nm depending on the selected material.

The transparent back electrode layer 42 may be made of any suitable materials, and is preferably a transparent conducting oxide (TCO) layer.

Advantageously, the transparent back electrode layer 42 may be made of a material selected from the group comprising FTO (fluorinated tin oxide), ITO (indium tin oxide), IOH (hydrogen doped indium oxide), ZnO and SnO₂.

Typically, said transparent back electrode layer 42 has a thickness comprised between 40 nm and 2000 nm depending on the selected material.

Advantageously, the back reflector 44 may be formed by a polymeric encapsulant layer by using the typical polymeric encapsulants disclosed in the "background of the invention" section, as poly vinyl butyral (PVB), ethylene vinyl acetate (EVA) ionomers, silicone and fluoropolymers based materials. Preferably, said polymeric encapsulant layer forming the back reflector 44 may be white or may have exactly the same color as the color of the solar module as defined above.

Typically, said back reflector 44 has a thickness comprised between 0.2 mm and 0.6 mm.

Advantageously, the back sheet 46 may be a back glass sheet or a back polymeric sheet.

Typically, said back sheet 46 has a thickness comprised between 1mm mm, and 6 mm.

The present invention relates also to a method for producing a solar module as defined below, said method comprising the following steps of:
- depositing on a front sheet 30 an amorphous silicon photoelectric device 32 comprising at least a transparent front electrode layer 34, a p-type doped silicon layer 36, an intrinsic silicon layer 38, a n-type doped silicon layer 40, and a transparent back electrode layer 42, the intrinsic silicon layer 38 of the amorphous silicon photoelectric device 32 having a thickness comprised between 50 nm and 300 nm, and preferably comprised between 100 nm and 200 nm;
- depositing on the amorphous silicon photoelectric device 32 a colored encapsulant layer 48 which comprises a coloring agent chosen in such a way that the solar module has a color within a region defined by an x value of 0.15 to 0.75 and a y value of 0.10 to 0.70, and preferably defined by an x value of 0.28 to 0.65 and a y value of 0.20 to 0.50, in a chromaticity diagram of a CIE 1931 Yxy color system using a white light source measured with a D65 light source;
- depositing on the colored encapsulant layer 48 a back reflector 44, and
- depositing on the back reflector 44 a back sheet 46.

Preferably, the step of depositing the colored encapsulant layer 48, directly after the back electrode layer 42, may be made through a lamination process.

Preferably, the step of depositing the back reflector 44 may be made through a lamination process of a polymeric encapsulant layer.

The lamination process is well know by one skilled in the art and has been disclosed in various literatures, as given above in the "Background of the invention" section.

Example:

The following example illustrates the present invention without however limiting the scope.

A solar module of the invention may be prepared by the steps of:
a) providing a solar grade glass substrate with a typical thickness of 3 mm, most preferably textured, possibly by embossing .
b) depositing a ZnO front electrode layer by low-pressure CVD, with a typical thickness of 1.4 µm.
c) segmenting the front TCO layers via laser scribing P1
d) depositing sequentially by PECVD a p-type doped Si layer with a thickness of 7 nm, the intrinsic a-Si:H layer with a thickness of 120 nm, a n-type doped Si layer with a thickness of 15 nm
e) segmenting the Si layers via laser scribing P2
f) depositing a back TCO layer which is substantially transparent, such as ZnO grown by LPCVD with a thickness of 1.4 µm
g) segmenting the solar cells via a laser scribing P3 to ensure series interconnection of the TF Si active elements
h) connecting the solar module with two soldered or glued copper ribbons
i) applying the colored polymer sheet with a thickness of 0.3mm , using a colored polymer (Trosifol®) colour supplied by Kuraray)
j) applying the back reflector colored polymer sheet with a thickness of 0.5mm, using a white polymer (Trosifol® ultra white supplied by Kuraray)
k) applying the back substrate (glass or polymeric foil)
l) laminating the solar module at a temperature between 110°C and 160°C under a pressure of 400mb to 1000mb
m) assembling the junction box at the back of the laminated module.

The obtained solar module as a terra-cotta like color with x= 0.46 and y =0.39 in a chromacity diagram of a CIE 1931 Yxy color system using a white light source measured with a D65 light source.

The electrical characteristics are measured with standard conditions of AM 1.5G illumination.

ISC (short-circuit current) of such a module of the invention is comprised between 9.00mA/cm2 to 10.20 mA/cm2, compared to a module with a reference encapsulation scheme which has an ISC comprised between 12.32 to 14.5 mA/cm2.

## Claims

1. Solar module comprising at least:
- a front sheet (30),
- an amorphous silicon photoelectric device (32) comprising at least a transparent front electrode layer (34), a p-type doped silicon layer (36), an intrinsic silicon layer (38), a n-type doped silicon layer (40), and a transparent back electrode layer (42),
- a back reflector (44),
- a back sheet (46),
**characterized in that** the intrinsic silicon layer (38) of the amorphous silicon photoelectric device (32) has a thickness comprised between 50 nm and 300 nm, and preferably comprised between 100 nm and 200 nm and **in that** the solar module further comprises, between the amorphous silicon photoelectric device (32) and the back reflector (44), a colored encapsulant layer (48) which comprises a coloring agent chosen in such a way that the solar module has a color within a region defined by an x value of 0.15 to 0.75 and a y value of 0.10 to 0.70, and preferably defined by an x value of 0.28 to 0.65 and a y value of 0.20 to 0.50, in a chromaticity diagram of a CIE 1931 Yxy color system using a white light source measured with a D65 light source.

2. Solar module according to claim 1, **characterized in that** the colored encapsulant layer (48) is a polymeric layer.

3. Solar module according to anyone of claims 1 to 2, **characterized in that** the coloring agent is selected from the group comprising organic pigments, inorganic pigments, polymeric pigments and dyes.

4. Solar module according to anyone of claims 1 to 3, **characterized in that** the transparent front electrode layer (34) or the transparent back electrode layer (42) is made of a material selected from the group comprising FTO (fluorinated tin oxide), ITO (indium tin oxide), IOH (hydrogen doped indium oxide), ZnO and SnO₂

5. Solar module according to anyone of claims 1 to 4, **characterized in that** the front sheet (30) is a front glass sheet.

6. Solar module according to anyone of claims 1 to 5, **characterized in that** the back sheet (46) is a back glass sheet.

7. Solar module according to anyone of claims 1 to 6, **characterized in that** the back reflector (44) is formed by a polymeric encapsulant layer.

8. Solar module according to claim 7, **characterized in that** polymeric encapsulant layer forming the back reflector (44) is white.

9. Solar module according to anyone of claims 1 to 8, **characterized in that** it further comprises a textured glass sheet (50) deposited on the front sheet (30).

10. Solar module according to anyone of claims 1 to 8, **characterized in that** the front sheet (30) is a textured glass sheet.

11. Method for producing a solar module as defined in anyone of claims 1 to 10, **characterized in that** it comprises the following steps of:
- depositing on a front sheet (30) an amorphous silicon photoelectric device (32) comprising at least a transparent front electrode layer (34), a p-type doped silicon layer (36), an intrinsic silicon layer (38), a n-type doped silicon layer (40), and a transparent back electrode layer (42), the intrinsic silicon layer (38) of the amorphous silicon photoelectric device (32) having a thickness comprised between 50 nm and 300 nm, and preferably comprised between 100 nm and 200 nm;
- depositing on the amorphous silicon photoelectric device (32) a colored encapsulant layer (48) which comprises a coloring agent chosen in such a way that the solar module has a color within a region defined by an x value of 0.15 to 0.75 and a y value of 0.10 to 0.70, and preferably defined by an x value of 0.28 to 0.65 and a y value of 0.20 to 0.50, in a chromaticity diagram of a CIE 1931 Yxy color system using a white light source measured with a D65 light source;
- depositing on the colored encapsulant layer (48) a back reflector (44),
and
- depositing on the back reflector (44) a back sheet (46).

12. Method according to claim 11, **characterized in that** the step of depositing the colored encapsulant layer (48) is made through a lamination process.

13. Method according to anyone of claims 11 to 12, **characterized in that** the colored encapsulant layer (48) is a polymeric layer.

14. Method according to anyone of claims 11 to 13, **characterized in that** the coloring agent is selected from the group comprising organic pigments, inorganic pigments, polymeric pigments and dyes.

15. Method according to anyone of claims 11 to 14, **characterized in that** the step of depositing the back reflector (44) is made through a lamination process of a polymeric encapsulant layer.

16. Method according to claim 15, **characterized in that** polymeric encapsulant layer forming the back reflector (44) is white.
